**Europäisches Patentamt**

**European Patent Office**

**Office européen des brevets**

(19)

(11) **EP 1 555 538 A1**

(12) # EUROPEAN PATENT APPLICATION

(43) Date of publication:
**20.07.2005 Bulletin 2005/29**

(51) Int Cl.7: **G01R 33/28**, G01R 33/46

(21) Application number: **04000720.5**

(22) Date of filing: **15.01.2004**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventors:<br>• **Gewiese, Bernd**<br>  **75334 Straubenhart (DE)**<br>• **Jung, Wulf-Ingo**<br>  **76532 Bade-Baden (DE)** |
| (71) Applicant: **Bruker BioSpin MRI GmbH**<br>**76275 Ettlingen (DE)** | (74) Representative: **Kohler Schmid Möbus**<br>**Patentanwälte**<br>**Ruppmannstrasse 27**<br>**70565 Stuttgart (DE)** |

(54) **Method of fast multidimensional NMR spectroscopy**

(57)    The present invention relates to a method of multidimensional NMR (Nuclear Magnetic Resonance) spectroscopy of a sample, employing at least one slice selective magnetic field gradient during excitation periods to assign different magnetic fields strength to a multitude of consecutive spatial regions in the sample, exciting nuclear spins in the consecutive spatial regions such that in subsequent evolution periods the excited spins in the different spatial regions evolve in different ways, detecting spatially resolved NMR signals from the excited spins during an acquisition period in the presence of a read gradient and reconstructing a multidimensional NMR spectrum of the sample from the detected signals characterized in that prior to and/or during the excitation periods the nuclear spins in the consecutive spatial regions are hyperpolarized. The inventive method firstly enables acquisition of a complete multidimensional NMR data set within a single scan comprising an enhanced signal-to-noise ratio and therefore enables quick investigation of dilute samples or samples which are only available in small amounts, in particular dynamic systems.

Fig. 2α

Fig 2b

FT($t_2$)

**Description**

The present invention relates to a method of multidimensional NMR (Nuclear Magnetic Resonance) spectroscopy of a sample, employing at least one slice selective magnetic field gradient during rf excitation periods to assign different magnetic field strengths to a multitude of consecutive spatial regions in the sample, exciting nuclear spins in the consecutive spatial regions such that in subsequent evolution periods the excited spins in the different spatial regions evolve in different ways, detecting spatially resolved NMR signals from the excited spins during an acquisition period in the presence of a read gradient and reconstructing a multidimensional NMR spectrum of the sample from the detected signals.

In contrast to 1D NMR spectroscopy, multidimensional NMR spectroscopy enables one to gain additional information about an examined sample, for example information about spin coupling. Yet for acquiring this information, scanning a series of signals $S(t_2)$ as a function of a $t_1$ time variable which undergoes parametric incrementation throughout independent experiments is necessary. Multidimensional NMR experiments are therefore afflicted with long acquisition times.

In Proceedings of the National Academy of Science (USA) 2002, vol. 99, No. 25, 15858-15862, Frydman et al. propose a general approach whereby this serial mode of data acquisition is parallelised, allowing an acquisition of a complete 2D NMR data set during the recording of a single transient. In this approach the usual time encoding of the signals is replaced by an equivalent spatial encoding of the spin evolution frequencies by dividing the sample into a series of independent subsamples. This spatial encoding can be parallelised, making it possible to collect the equivalent of a complete $S(t_1, t_2)$ data set within a single scan. The acquisition time of multidimensional NMR experiments can thus be shortened by orders of magnitude. This method is also described in greater detail in Journal of the American Society 2003, 125, 9204-9217 and in Journal of Magnetic Resonance 2003, 164, 351-357. We refer explicitly to all modifications and variants disclosed explicitly and implicitly in these three references.

2D NMR measurements are of course also of particular interest for the examination of smallest amounts of a substance. Further the usage of diluted samples and small sample tubes, in which only small amounts of a sample can be contained, is common. In both cases only few sample material and therefore correspondingly few nuclear spins are available for excitation and detection. Partitioning the samples into a multitude of subsamples as suggested by Frydman et al. implies an even smaller amount of polarisable nuclear spins available for each excitation, which results in a poor NMR-signal and a poor signal-to-noise ratio, respectively. To improve the signal-to-noise ratio it would be necessary to repeat the measurement - yet, this is often not desirable or even not possible, in particular when dynamic systems are concerned.

In WO03/089657 a method for phenotyping by determining protein activity is described whereby the nuclear polarization of the NMR active nuclei present in the sample is enhanced by hyperpolarisation prior to NMR analysis. The difficulty of determining the rate of disappearance of the sample compound with time, is mentioned. Several methods for hyperpolarising NMR active nuclei are also described in WO00/40988, all of which are incorporated by reference herein.

US 6,515,260, WO02/36005 and WO02/37132 each discloses a method for enhancing the nuclear polarisation of a substance prior to an NMR measurement. Prior to the excitation period a freezing and cooling down to very low temperatures followed by subsequent rapid heating and melting or dissolving of the NMR sample from a temperature of e.g. 3K to about room temperature is carried out in order to achieve and preserve at least in part a high nuclear polarisation corresponding to the low temperature. Additional enhancement of the polarisation is - achieved by use of dynamic nuclear polarisation (DNP) transferring polarization from electron spins to the nuclear spins of the sample at the low temperature. The methods involve a quick sample transfer from a low temperature pre-polarising and DNP position (usually at a lower magnetic field strength) to an NMR measuring position at about room temperature (and usually at a higher magnetic field strength). It is also conceivable to combine these positions. However, this requires that the DNP is performed at an EPR frequency corresponding to the NMR measuring field.

It is an object of the present invention to propose a method for fast acquisition of multidimensional NMR spectra of arbitrary, in particular small and/or dilute, samples wherein the multidimensional NMR spectra have an improved signal-to-noise ratio.

This object can be achieved by a method of multidimensional NMR spectroscopy as mentioned above characterized in that prior to and/or during the excitation periods the nuclear spins in the consecutive spatial regions are hyperpolarised.

The hyperpolarised sample is partitioned into a series of N independent subsamples, each of them characterized by an individual $t_1$ evolution, as per se known from Frydman et al.. However, as a result of the hyperpolarisation each subsample contains nuclear spins with an increased amount of polarisation which might be excited within the NMR-measurement. A time incremented series of N spatially selective excitationsequences is applied throughout the sample. The time shifted excited nuclear spins are allowed to develop during an evolution period before they are detected spatially resolved during an acquisition period. This method allows acquiring a fast multidimensional NMR spectrum with a dramatically improved signal-to-noise ratio. Thus analysing of small amounts of substances by fast multidimensional NMR spectroscopy is enabled.

The inventive multi-dimensional method of NMR spectroscopy is based on partitioning the sample in consecutive spatial regions and investigating these spatial regions in parallel, i.e. in a common scan. In each of these spatial regions, according to the invention, hyperpolarisation is used. Its effect is an increased polarisation of nuclear spins, compared to conventional polarisation methods. Thus the relatively small volume of sample material in each spatial region can, by means of the invention, still yield enough NMR signal to obtain an acceptable signal to noise ratio. Otherwise in many cases the elegant fast multidimensional NMR spectroscopy method would simply fail because of lack of signal or lead to inacceptable measuring times. The inventive application of a hyperpolarisation, prior to or during the excitation period, allows therefore to do without the large amount of sample volume which is necessary in the methods proposed by Frydman et al.. In particular, diluted samples or samples from which only small amounts of material are obtainable can be measured with good accuracy by the inventive method. Moreover, the inventive method provides the opportunity to obtain a multidimensional NMR spectrum from rapidly changing dynamic sample systems with only few efforts. Sample systems changing on a quicker time scale than the time scale of consecutively executed NMR scans are, exclusively by means of the invention, now accessible by multidimensional single scan NMR spectroscopy.

In a preferred variant of the inventive method a mixing period is inserted between the evolution periods and the detection period. During this mixing period the spin system is allowed to further evolve.

The spatially resolved NMR signals are advantageously detected during a gradient echo train. The gradient echo train supports the invention with its capability of decoding the acquired information of the single subsamples.

In a preferred variant of the invention the acquisition period is preceded by a refocusing pulse. This allows compensating non-uniformities of the external field and gaining higher signal intensity during detection.

In a preferred variant of the invention the individual spatial regions are selectively excited at different points in time during the excitation period. As a result, each subsample is characterized by an individual $t_1$ evolution time. This is advantageous for gaining information about the spin-spin interaction within the sample, for example. Alternatively the spatial regions can be excited at one common point of time, in particular with a single pulse or a single set of pulses, what simplifies the excitation procedure.

It is another aspect of the inventions that the selective excitation of the spins involves a train of inverting gradients. Application of the inverting gradients for equal time lengths results in a gradient echo where the evolution period reflects solely the internal coupling frequencies, but not the frequencies defined by the slice selective field gradient. Thus any unintended magnetization effect resulting from the slice selective field gradient becomes compensated.

In an advantageous variant of the inventive method the NMR spectrum is a 2D NMR spectrum, in particular a COSY-, TOCSY-, NOESY-, TROSY-, HETCOR-, HMQC-, or a HSQC-spectrum. These spectra are particularly suitable for the invention.

A highly preferred variant of the present invention involves only one single scan. A typical scan comprises a hyperpolarization sequence, the excitations of spins of the subsamples, optionally a mixing period and an acquisition period for detecting the NMR signals. This is the most time saving method for data acquisition and therefore also suitable for investigation of dynamic systems.

It is also possible that the inventive method comprises several scans. The single results of the several scans can be combined in one single plot. This may be advantageous for extension of the measuring field and compensation for field inhomogeneities may be achieved.

The hyperpolarisation of the nuclear spins is preferably carried out either by means of polarisation transfer from a hyperpolarised noble gas or a mixture of hyperpolarised noble gases, by means of polarization transfer using dynamic nuclear polarisation, by means of parahydrogen induced polarization, by means of spin refrigeration technique or by means of "brute force".

Hyperpolarisation is most preferably carried out by means of Overhauser-DNP, solid state effect DNP, or thermal mixing DNP.

In a preferred variant DNP hyperpolarisation employs a microwave source, The microwave source is suitable to induce the polarisation transfer.

The sample is advantageously contained in a vessel with an extension comparable to the microwave wavelength in at least one dimension. This optimises the penetration of microwave radiation into the sample material during hyperpolarisation.

Another aspect of the invention comprises that the sample is contained in a multitude of parallel slices or capillaries, each of which preferably have an extension comparable to the microwave wavelength in at least one dimension for the above mentioned reason.

Preferably, the slices or capillaries are arranged in such a way that they are compatible with the individual spatial regions of the sample. E.g., slices or rows of capillaries may coincide with these regions. This optimises the usable signal. However, slices may also be directed perpendicularly to the main extension direction of the spatial regions, which usually are also parallel slices. Such an arrangement may lead to a more even distribution of pre-polarisation between the individual spatial regions.

Another aspect of the invention is that pre-polarisation, in particular DNP is carried out at a location of lower magnetic field strength than the NMR measurement. This has the advantage that microwave frequencies may be employed that are still in a standard range and that the penetration depths stay sufficiently large to pre-polarise a large fraction of the sample.

To improve the NMR result, it is advantageous if the sample contains or is in contact with an optimised contrast agent. Contrast agents are easily polarisable, and polarisation transfer from them to the nuclei of interest improve NMR data acquisition. Using non toxic contrast agents especially improve the NMR results for in vivo measurements. Such contrast agents using free radicals are e.g. known from WO91/12024, WO93/02711, WO96/39367, WO98/001766 and US 6,311,086.

In order to avoid or reduce unintentional influences of the contrast agent on the results of NMR measurements, in particular on relaxation times, the contrast agent may be partially or completely removed prior to the excitation.

In some cases it might be advantageous that the sample is hyperpolarised at a first location and subsequently transferred to an NMR measuring location in a distance from the first location. This is advantageous for executing space intensive preparations during the hyperpolarisation like cooling the sample to very low temperatures and/or irradiating it with microwave radiation and/or heating it up again by melting or dissolving, which would be realisable at the measuring location only with great efforts.

In a preferred variant of the invention the sample transfer is effected by a fast, preferably automated, shuttle mechanism within less than 5 seconds, preferably less than 1 second, most preferably less than 1/10 of a second. This automatisation guaranties reproducible, defined initial conditions, which is very important because the hyperpolarisation may decrease in the course of time.

In another preferred variant of the invention the sample is hyperpolarised at the measuring location. In this way, the time for transferring the sample from a first location to the measuring location can be saved. This is of importance for dynamic systems and also for pre-cooled and re-heated hyperpolarised samples since, as mentioned above, hyperpolarisation will decrease with progressive time.

Since most high resolution NMR experiments involve investigation of liquid samples, another aspect of the invention is that the sample is liquid.

In a preferred variant, the sample transport is carried out via a flow transfer line. It constitutes a simple device to transfer in particular liquids to the measuring location in a reproducible way, in particular from a hyperpolarisation location.

To take advantages of the invention in human medicine, in a preferred variant the sample is a biological sample, in particular a body fluid including blood, blood plasma, urine, breast milk etc.

To achieve equal preconditions for each subsample, i.e. each spatial region, the sample is preferably homogenous.

The evaluation of the results is simplified if the consecutive spatial regions are of equal size. That makes it easier that each spatial region (slice) contains a comparable or equal amount of polarised spins.

To achieve optimal polarization of the sample, in a preferred variant of the method the hyperpolarisation is carried out at a temperature below room temperature, in particular below 100 K, preferably below 5 K. Since the ratio of the population numbers of two occupied levels of different energies is characterized by the Boltzmann distribution and therefore proportional to

$$ e^{\frac{-\Delta E}{k_H T}}, $$

polarisation of the sample can be increased by freezing and cooling down the sample.

Another aspect of the present invention is, that the sample is heated up again to about room temperature prior to the excitation period. Liquid samples may therefore be frozen prior hyperpolarisation and melted or dissolved immediately prior to the excitation. Thus very high sensitivity NMR spectra can be acquired.

The sample is preferably heated up rapidly, in particular in less than 5 seconds, preferably in less than 1 second, most preferably in less than 1/10 second. Rapid heating and an immediate start of the NMR measurement is advantageous since a hyperpolarised sample begins to loose its hyperpolarisation when it is heated up. To maintain as much polarisation as possible, it is advantageous to execute the heating in the above-mentioned manner.

Hyperpolarised nuclear spins comprise advantageously $^1$H, $^{13}$C, $^{15}$N, $^{31}$p, $^{19}$F, $^{23}$Na and/or $^{29}$Si, which are of particular significance in NMR spectroscopy of chemical and biological systems.

Because of the rapid data acquisition and the high sensitivity, the above described method is usable as part of an online process control system, for example as a controlling tool for chemical reactions, complex analyses, syntheses and transformation methods.

Because of its high speed and sensitivity, in a preferred variant of the invention a multitude of consecutive scans according to the inventive method as described above are conducted to inspect the time dependent development of a dynamic system, e.g. monitoring of reaction kinetics.

The inventive method may also comprise using an assay reagent containing at least one NMR active nucleus to perform an assay, hyperpolarising at least one NMR active nucleus of the assay reagent, analysing the assay reagent by NMR and optionally using the NMR data obtained to generate further assay results, and may in particular be extended to and combined with the methods that are per se described in detail in WO 00/40988.

In order to determine in vivo protein activity the sample may be collected from a human or non-human animate body preadministered with at least one probe compound containing at least one NMR active kind of nucleus, and may in particular be extended to and combined with the methods that are per se described in detail in WO03/089656.

The inventive method may also be used to phenotype a human or non-human individual by obtaining a characteristic of that individual, and may in particular be extended to and combined with the methods that are per se described in detail in WO03/089657.

In order to investigate the fate of a test compound, the test compound may be administered to a biological system in which the fate is to be studied and the system or a sample extracted from the system analysed and may in particular be extended to and combined with the methods that are per se described in detail in WO01/96895.

During the pulse sequences of the inventive method, rf pulses with variable pulse angles and/or pulse durations may advantageously be used. In this way, the speed of the method may be further increased and the signal-to-noise ratio may be optimised.

Further aspects and advantages of the present invention are discussed with respect to the following figures of the drawing. It is self-evident that the invention is not limited to the described examples but can be varied within the scope of the claims.

The present invention explicitly includes the combination of any of the cited hyperpolarisation methods as disclosed or implied in the respective references with any of the fast multidimensional NMR spectroscopy methods as disclosed or implied in the respective references.

It is straightforward to apply the present invention to future alternative methods of hyperpolarisation and/or future fast multidimensional NMR methods.

The drawings show:

Fig. 1a   a schematic view of a first variant of the inventive method including hyperpolarization prior to the excitation period;

Fig. 1b   a schematic view of a second variant of the inventive method including hyperpolarization during the excitation period;

Fig. 2a   shows slice selective excitation of the sample (STATE OF THE ART);

Fig. 2b   a spectrally selective data acquisition, (STATE OF THE ART); and

Fig.3   spectrally selective excitation and data acquisition using alternating field gradients, in accordance with the invention.

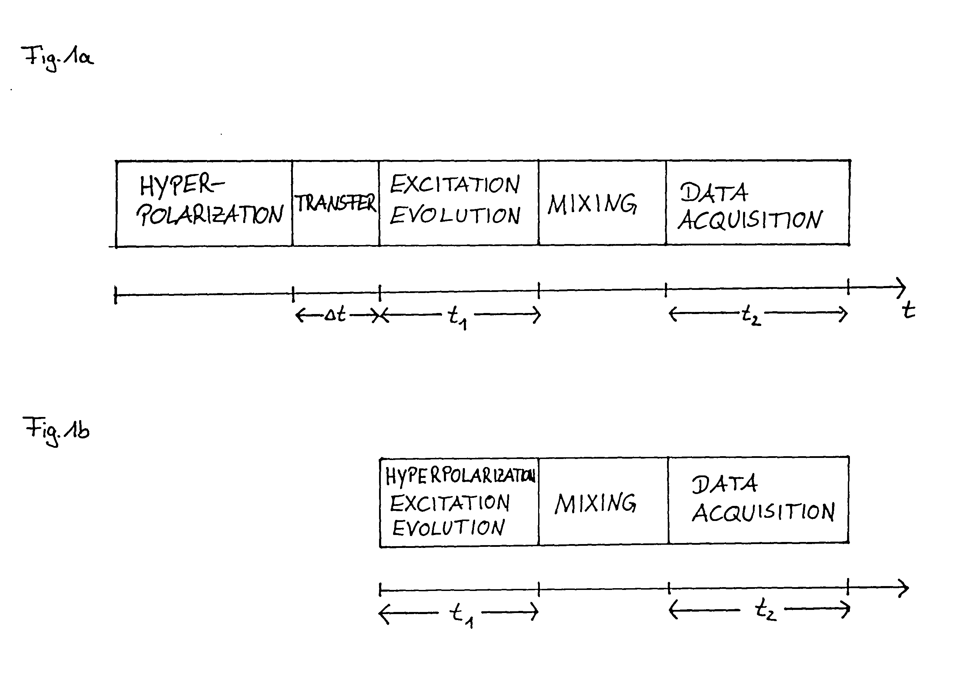

In **Fig. 1a** a schematic view of the inventive method is shown whereby hyperpolarisation of the nuclear spins is carried out as a first step prior to excitation. The hyperpolarisation may take place at a first location which is different from the measuring location. This may be advantageous in view of handling of the sample during hyperpolarisation. Further the requirements which the NMR equipment has to fulfil, are lower. This is of special interest since the space at the measuring location in common NMR spectrometers is limited. On the other hand, by carrying out hyperpolarisation outside the NMR spectrometer, some effort has to be made to transfer the sample from the first location, where hyperpolarisation is carried out, to the measuring location. The time which is needed for the transfer is depicted as $\Delta t$ in Fig.1a. With regard to a comparison of different measurements it is desirable to carry out the transfer in a reproducible way. A simple way to realise this is the usage of a flow transfer line comprising a tube, wherein the sample is surrounded by air bubbles and transported to the measuring location while applying a pressure pulse to one end of the tube. This is most suitable for liquid samples, but can also be used to transport an encapsulated solid sample, such as a powder material in a sample cylinder following the known message-in-a-bottle method. It is also possible to hyperpolarise the sample at the measuring location. $\Delta t$ can then be varied in an arbitrary way, for example to influence the initial conditions of the system. A time scale is shown in Fig. 1a which shows that an excitation and an evolution period, which is characterized by the individual evolution times of the excited nuclear spins, is followed by a conventional mixing sequence that affects all spins of the sample simultaneously. During an acquisition time $t_2$ data acquisition is carried out.

Since the transfer of the sample from the first location, at which the sample is hyperpolarised, to the measuring location takes some time $\Delta t$ (shown in Fig. 1a), the degree of the hyperpolarisation will decrease within that time $\Delta t$, which is in general not desirable. This is of importance for example in the case that the sample is heated up again after hyperpolarisation at low temperatures, since the degree of the polarisation is inversely proportional to the temperature and therefore decreases during and after the heating process with progressive time. It may be therefore desirable to minimise the time $\Delta t$ between hyperpolarisation and excitation. To bypass this problem, a second variant of the inventive method comprising a hyperpolarisation process of the nuclear spins during the excitation period is proposed. This variant of the invention is schematically shown in **Fig. 1b.** Since in this case hyperpolarisation and excitation takes place at the same time, the sample has to be hyperpolarised at the measuring location. Therefore no transfer mechanism is needed to transfer the hyperpolarised sample. The further proceeding is the same as in the above mentioned variant of the invention.

There are several ways to carry out hyperpolarisation. Some preferred methods are reviewed herein briefly.

A preferred way for hyperpolarising the NMR active nuclei according to the invention is the polarisation transfer from a hyperpolarised noble gas. Noble gases having non-zero nuclear spin can be hyperpolarised, that means they can have their polarisation enhanced over the equilibrium polarisation, e.g. by use of circularly polarised light. These hyperpolarised gases, e.g. $^3$He or $^{129}$Xe, are allowed to mix with the sample and the hyperpolarization is transferred to the sample.

For parahydrogen induced polarisation, hydrogen is cooled down to a low temperature (preferably to 20K or less) to give parahydrogen enriched hydrogen, which is used to hydrogenate an unsaturated target organic molecule (containing NMR active nuclei) imparting a non-thermodynamic spin configuration to the target molecule.

Further a spin refrigeration method can be used for hyperpolarisation. The system is doped with a suitable paramagnetic material in crystal form. The process is carried out by rotating sample whereby the electron paramagnetic resonance is brought in contact with the nuclear spins which results in a decrease in the nuclear spin temperature.

The hyperpolarisation transfer can also be carried out by use of a very high field at very low temperature, also known as "brute force".

Another preferred way for hyperpolarising the NMR active nuclei is the dynamic nuclear polarisation method affected by a DNP agent (paramagnetic species). The sample is mixed with the DNP agent, for example a transition metal ion as chromium (V) or manganese (II) and/or a free radical generator or other particles having associated free electrons. The DNP agent is excited by means of a microwave source. Polarisation transfer from the DNP agent to the NMR active nucleus happens upon decay to the ground state. DNP can be carried out by means of Overhauser effect, solid effect and by thermal mixing effect. Since the excitation of the DNP agent is carried out by a microwave source it is advantageous if the sample is contained in a vessel with extensions comparable to the microwave length in at least one dimension to ensure optimal injection of the microwave radiation into the sample material. To further enhance the obtained signal, it is also possible to use a multitude of vessels, each of which has extensions comparable to the microwave length in at least one dimension,.

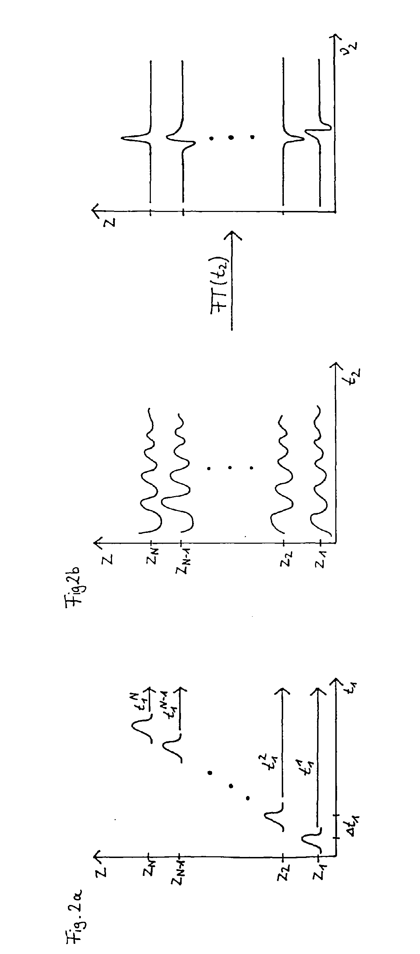

According to the method suggested by Frydman et al. and cited above, once the sample is at the measuring location, a magnetic field gradient is applied along the main axis of a conventional sample tube on top of the homogenous external magnetic field by using gradient coils which are available in a majority of common NMR systems. This magnetic gradient is the source of spectral heterogeneities within the sample which results in partitioning the sample into a series of N independent subsamples. Concerning a magnetic gradient along the main axis z of the sample, the sample is divided into subsamples each of which is located at a position $z_i$ within the sample. As shown in Fig. **2a,** this enables a sequential excitation of spins of the different subsamples by use of a train of consecutive pulses each spectrally selective. The spins of each subsample are therefore excited at different times and thus each subsample is characterized by an individual $t^i_1$ evolution time. The consecutive pulses may occur in equal time steps $\Delta t_1$. Thus the difference of two arbitrary evolution times is a multitude of $\Delta t_1$. Yet, it is also possible to choose non equidistant time steps between the consecutive pulses.

During a time $t_2$, acquisition is carried out using a gradient echo train to read out the echo pulses spectrally selective. Since the evolution times $t^i_1$ differ from each other, spin echoes for different evolution times can be acquired, which gives information about the spin-spin coupling of the excited nuclei. Fig. 2b shows the spatial encoding of the $t_1$ evolution period as a function of $t_2$, whereby the ordinate shows the sample position and the abscissa shows the acquisition time $t_2$. A two-dimensional NMR spectrum is acquired by a subsequent Fourier transformation (FT).

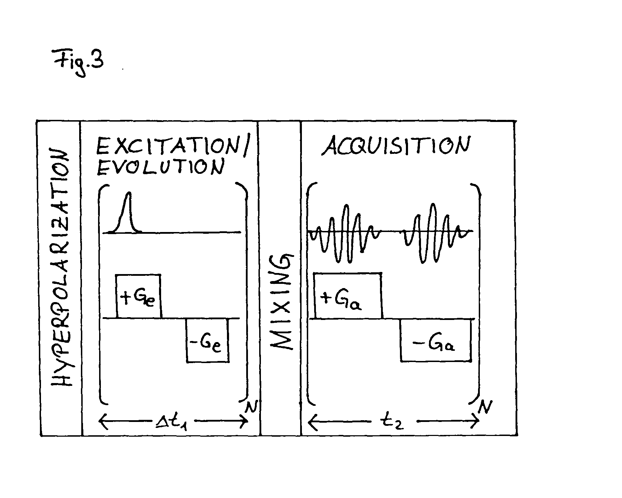

A more detailed depiction of the measuring periods according to the invention is shown in **Fig. 3**. The left panel of Fig. 3 shows a hyperpolarisation period followed by a train of frequency-shifted excitation pulses which are applied to the hyperpolarised subsamples in the presence of a magnetic field gradient $G_e$, whereby synchronised reversals in the sign of the field gradient are applied during the excitation period. By choosing the period length $\Delta t_1$ of the inverting field gradient, whereby $\Delta t_1$ constitutes the time gap between two consecutively carried out excitations of subsamples, compensation of any magnetisation effect resulting from the magnetic field gradient is possible. Therefore an evolution of the hyperpolarised spins that is solely dictated by the internal spin evolution frequencies can be achieved and therefore only the internal coupling frequencies are reflected by the signal. In this example, after a mixing period the precession frequencies are monitored for each subsample by using an echo planar imaging (EPI) type protocol (right panel).

With any variant of the inventive method complete two-dimensional NMR data sets showing a high signal-to-noise ratio can be acquired. By executing hyperpolarisation to a sample which is spectrally heterogeneous, the inventive method firstly enables acquisition of a complete multidimensional NMR data set within a single scan comprising an enhanced signal-to-noise ratio and therefore enables quick investigation of dilute samples or samples which are only available in small amounts, in particular dynamic systems.

**Claims**

1. A method of multidimensional NMR (=nuclear magnetic resonance) spectroscopy of a sample, employing at least one slice selective magnetic field gradient during excitation periods to assign different magnetic field strengths to a multitude of consecutive spatial regions in the sample, exciting nuclear spins in the consecutive spatial regions such that in subsequent evolution periods the excited spins in the different spatial regions evolve in different ways, detecting spatially resolved NMR signals from the excited spins during an acquisition period in the presence of a read gradient and reconstructing a multidimensional NMR spectrum of the sample from the detected signals, **characterised in that** prior to and/or during the excitation periods the nuclear spins in the consecutive spatial regions are hyperpolarised.

2. Method according to claim 1, **characterised in that** a mixing period is inserted between the evolution periods and the detection period.

3. Method according to any one of the preceding claims, **characterised in that** the spatially resolved NMR-signals are detected during a gradient echo train.

4. Method according to claim 3, **characterised in that** the acquisition period is preceded by a refocusing pulse.

5. Method according to any one of the preceding claims, **characterised in that** the spins of the individual spatial regions are selectively excited at different points in time during the excitation period.

6. Method according to claim 5, **characterised in that** the selective excitation of the spins involves a train of inverting gradients.

7. Method according to any one of the preceding claims, **characterised in that** the multidimensional NMR-spectrum is 2-dimensional, in particular a COSY-, TOCSY-, NOESY-, TROSY-, HETCOR-, HMQC- or a HSQC-spectrum.

8. Method according to any one of the preceding claims, **characterised in that** it involves only one single scan.

9. Method according to any one of claims 1 to 7, **characterised in that** it comprises several scans which are combined.

10. Method according to any one of the preceding claims, **characterised in that** hyperpolarisation is carried out by means of polarisation transfer from a hyperpolarised noble gas, or a mixture of hyperpolarised noble gases, by means of polarisation transfer using dynamic nuclear polarisation (DNP), by means of parahydrogen induced polarization, by means of spin refrigeration technique, or by means of thermodynamic equilibrium at very low temperature and high field.

11. Method according to claim 10, **characterised in that** hyperpolarisation is carried out by means of Overhauser-DNP, solid-state-effect-DNP, or thermal-mixing DNP.

12. Method according to claim 10, **characterised in that** DNP-hyperpolarisation employs a microwave source.

13. Method according to claim 12, **characterised in that** the sample is contained in a vessel with an extension comparable to the length of the microwave radiation of the microwave source in at least one dimension.

14. Method according any one of the preceding claims, **characterised in that** the sample is contained in a multitude of parallel capillaries or slices that preferably are aligned in a fixed relationship with respect to the different spatial regions.

15. Method according to one of the claims 10 to 14, **characterised in that** DNP is carried out at a location of lower magnetic field strength than the NMR measurement.

16. Method according to any one of the preceding claims, **characterised in that** the sample contains a contrast agent.

17. Method according to claim 16, **characterised in that** the contrast agent is partially or completely removed prior to the excitation.

18. Method according to any one of the preceding claims, **characterised in that** the sample is hyperpolarised at a first location and subsequently transferred to a measuring location in a distance from the first location.

19. Method according to claim 18, **characterised in that** sample transfer is effected by a fast shuttle mechanism within less than 5 seconds, preferably less than1 second, most preferably less than 1/10 of a second.

20. Method according to any one of claims 1 to 17, **characterised in that** the sample is hyperpolarised at the measuring location.

21. Method according to any one of the preceding claims, **characterised in that** the sample is liquid.

22. Method according to claim 18 or 21, **characterised in that** the sample transport is carried out via a flow transfer line.

23. Method according to any one of the preceding claims, **characterised in that** the sample is a biological sample, in particular a body fluid.

24. Method according to any one of the preceding claims, **characterised in that** the sample is homogeneous.

25. Method according to any one of the preceding claims, **characterised in that** the consecutive spatial regions are of equal size.

26. Method according to any one of the preceding claims, **characterised in that** hyperpolarisation is carried out at temperature below room temperature, in particular below 100 K, preferably below 5 K.

27. Method according to claims 26, **characterised in that** the sample is heated up again to about room temperature prior to the excitation period.

28. Method according to claim 27, **characterised in that** the sample is heated up rapidly, in particular in less than 5 seconds, preferably less than 1 second, most preferably less than 1/10 of a second.

29. Method according to one of the preceding claims, **characterised in that** the nuclear spins comprise $^{1}$H, $^{13}$C, $^{15}$N, $^{31}$p, $^{19}$F, $^{23}$Na, and/or $^{29}$Si.

30. Method according to any one of the preceding claims, **characterised in that** it is usable in relationship with an online-process control system.

31. Method according to any one of the preceding claims, **characterised in that** reaction kinetics are monitored.

32. Method according to any one of the preceding claims, **characterised in that** it comprises using an assay reagent containing at least one NMR active nucleus to perform an assay, hyperpolarising at least one NMR active nucleus of the assay reagent, analysing the assay reagent by NMR and optionally using the NMR data obtained to generate further assay results.

33. Method according to any one of the preceding claims, **characterised in that** in order to determine in vivo protein activity the sample is collected from a human or non-human animate body preadministered with at least one probe compound containing at least one NMR active kind of nucleus.

34. Method according to claim 33, **characterised in that** it is used to phenotype a human or non-human individual by obtaining a characteristic of that individual.

35. Method according to anyone of the preceding claims **characterised in that** in order to investigate the fate of a test compound, the test compound is administered to a biological system in which the fate is to be studied and the system or a sample extracted from the system is analysed.

36. Method according to anyone of the preceding claims **characterised in that** it employs rf pulses with variable pulse angles and/or pulse durations.

EP 1 555 538 A1

Fig. 1a

| HYPER-POLARIZATION | TRANSFER | EXCITATION EVOLUTION | MIXING | DATA ACQUISITION |
|---|---|---|---|---|

$\leftarrow \Delta t \rightarrow$ $\leftarrow t_1 \rightarrow$ $\leftarrow t_2 \rightarrow$ $t$

Fig. 1b

| HYPERPOLARIZATION EXCITATION EVOLUTION | MIXING | DATA ACQUISITION |
|---|---|---|

$\leftarrow t_1 \rightarrow$ $\leftarrow t_2 \rightarrow$

Fig. 2a

Fig 2b

$FT(t_2)$

**Fig.3**

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| E | WO 2004/011899 A (FRYDMAN LUCIO ;YEDA RES & DEV (IL); FLEIT LOIS (US)) 5 February 2004 (2004-02-05) * page 2 - page 6 * * page 30; claim 31 * --- | 1-9,21, 24,31,36 | G01R33/28 G01R33/46 |
| D,Y | FRYDMAN LUCIO ET AL: "Principles and features of single-scan two-dimensional NMR spectroscopy." JOURNAL OF THE AMERICAN CHEMICAL SOCIETY, vol. 125, no. 30, 30 July 2003 (2003-07-30), pages 9204-9217, XP002280243 ISSN: 0002-7863 (ISSN print) see the whole document --- | 1-36 | |
| Y | ARDENKJAER-LARSEN J H ET AL: "Increase in signal-to-noise ratio of >10,000 times in liquid-state NMR" PROCEEDINGS OF THE NATIONAL ACADEMY OF SCIENCES OF THE UNITED STATES OF AMERICA 02 SEP 2003 UNITED STATES, vol. 100, no. 18, 2 September 2003 (2003-09-02), pages 10158-10163, XP002280244 ISSN: 0027-8424 see the whole document --- | 1-31,36 | |
| Y | WO 03/038395 A (PIERCE KIMBERLY L ;SEELEY JULIETTE A (US); GRANWEHR JOSEPH (US); H) 8 May 2003 (2003-05-08) * page 11, line 31 - page 17, line 8; figures 2,5,6 * --- | 1-9,18, 22 | |

TECHNICAL FIELDS SEARCHED (Int.Cl.7)

G01R

-/--

The present search report has been drawn up for all claims

| Place of search | Date of completion of the search | Examiner |
|---|---|---|
| MUNICH | 13 May 2004 | Lersch, W |

EPO FORM 1503 03.82 (P04C01)

**European Patent Office**

**EUROPEAN SEARCH REPORT**

Application Number

EP 04 00 0720

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | WO 00/40988 A (COOK NEIL ;KNOX PETER (GB); NYCOMED AMERSHAM PLC (GB); AXELSSON OK) 13 July 2000 (2000-07-13) * page 2, line 5 - page 17, line 32 * | 32,33 | |
| A | | 10,14, 16-18, 20,26 | |
| D,Y | WO 03/089657 A (LERCHE MATHILDE H ;GOLMAN KLAES (DK); ARDENKJAER LARSEN JAN HENRIK) 30 October 2003 (2003-10-30) * claim 1 * | 34 | |
| D,Y | WO 01/96895 A (COOK NEIL ;LOOKER MIKE (GB); BOSWORTH NIGEL (GB); KNOX PETER (GB);) 20 December 2001 (2001-12-20) * claim 1 * | 35 | |
| A | LEAWOODS J C ET AL: "Polarization transfer using hyperpolarized, supercritical xenon" CHEMICAL PHYSICS LETTERS, 15 SEPT. 2000, ELSEVIER, NETHERLANDS, vol. 327, no. 5-6, pages 359-364, XP002280245 ISSN: 0009-2614 see the whole document | 1,10,21, 26-29 | TECHNICAL FIELDS SEARCHED (Int.Cl.7) |
| A,D | US 6 515 260 B1 (ANDERSON WESTON) 4 February 2003 (2003-02-04) * column 1, line 6 - column 2, line 59 * * column 3, line 28 - column 6, line 23; figures 1-8 * | 10-13, 18-20, 26-28 | |

-/--

The present search report has been drawn up for all claims

| Place of search | Date of completion of the search | Examiner |
|---|---|---|
| MUNICH | 13 May 2004 | Lersch, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 04 00 0720

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | SHAPIRA BOAZ ET AL: "Arrayed acquisition of 2D exchange NMR spectra within a single scan experiment." JOURNAL OF MAGNETIC RESONANCE (SAN DIEGO, CALIF.: 1997) UNITED STATES DEC 2003, vol. 165, no. 2, December 2003 (2003-12), pages 320-324, XP002280246 ISSN: 1090-7807 see pages 321,324 --- | 14,31 | |
| A | SHAPIRA BOAZ ET AL: "Real-time 2D NMR identification of analytes undergoing continuous chromatographic separation." JOURNAL OF THE AMERICAN CHEMICAL SOCIETY. UNITED STATES 4 FEB 2004, vol. 126, no. 4, 4 February 2004 (2004-02-04), pages 1262-1265, XP002280247 ISSN: 0002-7863 published online 08-01-2004; see the whole document ----- | 30 | |

TECHNICAL FIELDS SEARCHED (Int.Cl.7)

The present search report has been drawn up for all claims

| Place of search | Date of completion of the search | Examiner |
|---|---|---|
| MUNICH | 13 May 2004 | Lersch, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 00 0720

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2004

| Patent document cited in search report | | Publication date | Patent family member(s) | | Publication date |
|---|---|---|---|---|---|
| WO 2004011899 | A | 05-02-2004 | WO | 2004011899 A2 | 05-02-2004 |
| WO 03038395 | A | 08-05-2003 | WO | 03038395 A2 | 08-05-2003 |
| | | | WO | 03038396 A2 | 08-05-2003 |
| | | | US | 2003077224 A1 | 24-04-2003 |
| | | | US | 2003165431 A1 | 04-09-2003 |
| WO 0040988 | A | 13-07-2000 | AU | 766923 B2 | 23-10-2003 |
| | | | AU | 1880300 A | 24-07-2000 |
| | | | CA | 2356442 A1 | 13-07-2000 |
| | | | EP | 1141738 A1 | 10-10-2001 |
| | | | WO | 0040988 A1 | 13-07-2000 |
| | | | JP | 2002534687 T | 15-10-2002 |
| WO 03089657 | A | 30-10-2003 | WO | 03089657 A1 | 30-10-2003 |
| WO 0196895 | A | 20-12-2001 | AU | 6407201 A | 24-12-2001 |
| | | | EP | 1290461 A1 | 12-03-2003 |
| | | | WO | 0196895 A1 | 20-12-2001 |
| | | | JP | 2004503786 T | 05-02-2004 |
| | | | US | 2004039281 A1 | 26-02-2004 |
| US 6515260 | B1 | 04-02-2003 | EP | 1350120 A1 | 08-10-2003 |
| | | | WO | 03040742 A1 | 15-05-2003 |

EPO FORM P0459

For more details about this annex : see Official Journal of the European Patent Office, No. 12/82